## Europäisches Patentamt

## European Patent Office

## Office européen des brevets

(11) Publication number: **0 106 623**
**B1**

(12) # EUROPEAN PATENT SPECIFICATION

(45) Date of publication of patent specification: **23.05.90**

(51) Int. Cl.[5]: **C 23 C 14/34**

(21) Application number: **83306022.1**

(22) Date of filing: **05.10.83**

(54) Sputtering apparatus.

(30) Priority: **05.10.82 JP 174778/82**
**05.10.82 JP 151138/82**

(43) Date of publication of application:
**25.04.84 Bulletin 84/17**

(45) Publication of the grant of the patent:
**23.05.90 Bulletin 90/21**

(84) Designated Contracting States:
**DE FR GB**

(56) References cited:
**DE-A-1 929 180**
**DE-B-1 765 144**
**FR-A-1 469 226**
**US-A-3 235 476**
**US-A-3 257 305**
**US-A-3 649 512**

**JOURNAL OF PHYSICS E: SCIENTIFIC INSTRUMENTS, vol. 5, no. 5, 1972, pages 417-419, GB; A. ZOZIME et al.: "Achievement of isolated and cooled targets for a cathodic sputtering device"**

(73) Proprietor: **FUJITSU LIMITED**
**1015, Kamikodanaka Nakahara-ku**
**Kawasaki-shi Kanagawa 211 (JP)**

(72) Inventor: **Nagashima, Setsuo**
**25-1, Kizukidaimachi Nakahara-ku**
**Kawasaki-shi Kanagawa 211 (JP)**

(74) Representative: **Fane, Christopher Robin King et al**
**HASELTINE LAKE & CO. Hazlitt House 28 Southampton Buildings Chancery Lane London, WC2A 1AT (GB)**

(56) References cited:

**JOURNAL OF THE ELECTROCHEMICAL SOCIETY, vol. 112, no. 10, October 1965, pages 1050-1051; M. BLOOM et al.: "The preparation of large-area silicon cathodes for use in reactive sputtering"**
**L.I. MAISSEL et al.: "Handbook of thin film technology", 1970, pages 3-38,4-12,4-13, McGraw-Hill Book Company, New York, US; "Application of sputtering to the deposition of films"**

Courier Press, Leamington Spa, England.

## Description

This invention relates to a process for preparing a patterned thin metal film by sputtering followed by dry-etching.

In the production of a semiconductor integrated circuit, it may be necessary to perform the etching processing of a thin film on semiconductor material produced by sputtering to 1 micron or to submicron (some tenths of 1 micron) dimensions by using a fine mask. Recently a dry etching process has been developed as means meeting this requirement. However, various problems not encountered in the conventional wet etching process arise.

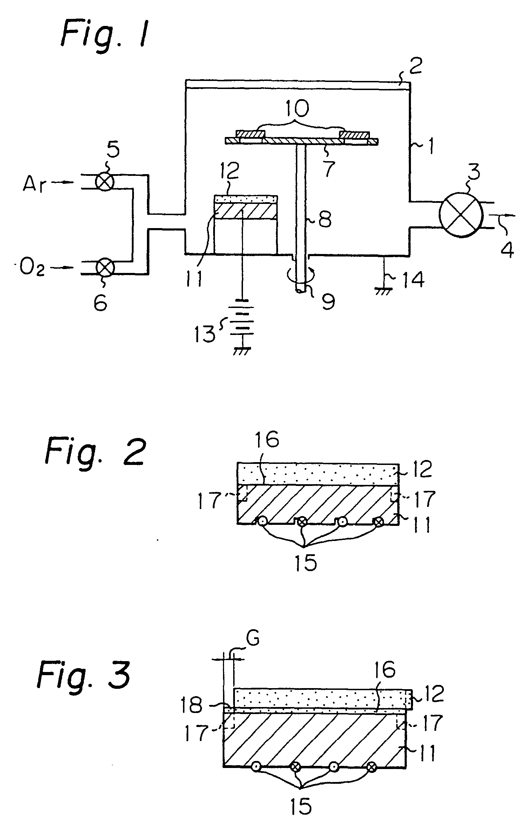

In order to clarify these problems, a conventional sputtering apparatus and a backing plate and target used in this apparatus will now be described with reference to Figs. 1 and 3 of the accompanying drawings, in which:

Fig. 1 is a diagram illustrating a conventional sputtering apparatus;

Fig. 2 is a sectional side view showing an example of the combination of a target and a backing plate, used in the conventional sputtering apapratus shown in Fig. 1; and

Fig. 3 is a sectional side view showing another example of the above combination;

Referring to Fig. 1 showing a conventional sputtering apparatus, a bell jar 1 has a lid 2 in the upper portion thereof and is in communication with evacuation means such as a vacuum pump through a valve 3, and air is removed through a passage 4 so as to produce vacuum within a chamber of the bell jar 1. Argon (Ar) and oxygen gas (O$_2$) are introduced into the bell jar 1 through valves 5 and 6, respectively.

A substrate holder 7 is arranged in the bell jar 1, and this substrate holder 7 is secured to a rotation shaft 8 and is rotated in a direction of the arrow 9 by a motor or the like disposed outside the bell jar 1. A substrate 10 composed of glass or another material is placed on the substrate holder 7, and a target 12 to be sputtered to the substrate 10, for example, chromium (Cr), is secured to a backing plate 11. A negative voltage of several hundred volts is applied to the sputtering target 12 from a voltage source 13. The voltage of the chamber 1 is maintained at the level of an earth voltage 14.

In the above-mentioned structure, when a negative voltage is applied to the sputtering target 12, a glow discharge is generated between the body (chamber) earth and the backing plate to produce a plasma, and argon introduced into the atmosphere of the chamber is ionized. By the shock caused when ionized argon impinges against the target 12 maintained at a negative potential, Cr is emitted and sputtered on the substrate 10 to form a film of Cr.

When the thus-formed metal film is etched with an aqueous acid solution as in case of the conventional wet etching process, no particular problem arises, but in case of the dry etching process recently adopted, the etching time may be abnormally prolonged and in the worst case, partial non-etching is caused.

When these problems' were examined, it was found that Cu constituting the backing plate was contained in the metal film sputtered on the substrate for which the etching time is long.

Referring to Fig. 2, the backing plate 11 ordinarily has a disc-like shape; a cooling pipe 15 is laid out on the backing plate 11 to cool the backing plate 11; for example, chromium is selected as the target material 12 and the backing plate 11 is integrally secured to the target material 12 by using a metal 16 such as indium. Copper or the like is ordinarily used for the backing plate 11. In the apparatus shown in Fig. 2, since the diameter of the backing plate 11 is the same as that of the target material 12 and they are integrally secured to each other, ionized argon impinges against a peripheral portion 17 of the backing plate 11 maintained at a negative voltage to emit molecules of copper. Accordingly, not only chromium but also copper may be sputtered onto the substrate 10. Fig. 3 illustrates the state in which a slippage G having a length of about 1 mm is formed by a divergence between the backing plate 11 and the target material 12 when the target material 12 is secured to the backing plate 11 by using a metal such as indium. In this case, ionized argon impinges also against the indium metal 16, that is, the slippage portion 18 to release molecules of indium. Furthermore, the backing plate 11 contains not only copper but also impurities such as iron, and molecules of these impurities may be emitted and sputtered on the substrate.

It has been found that dry etching of a metal film containing impurities such as copper is difficult.

US—A—3 257 305, US—A—3 235 476 and J. Electrochem, Soc., *112* [10], pp. 1050—1051 (October 1965) describe a sputtering apparatus wherein at least the peripheral portion of the backing plate adjacent to the sputtering target is covered with the same material as the material of the sputtering target.

In Journal of Physics E: Scientific Instruments, Vol. 5, No. 5, 1972, pages 417—419. A Zozime et al disclose targets mounted on a cooled copper base but insulated therefrom by a plate of alucer (alumina ceramic) and having a mask mounted in front of the target.

The present invention provides a process for preparing a patterned thin metal film comprising the steps of sputtering a sputtering target by applying a voltage to the sputtering target in a vacuum chamber to form a thin metal film on a substrate and, then, dry-etching the thin metal film to effect patterning thereof, wherein said sputtering target is composed of chromium, aluminium or gold, is bonded without an intervening insulating layer to a backing plate composed of a metal different from the sputtering target and containing copper, and covers the entire front surface of said backing plate, and the entire peripheral portion of the backing plate is covered with a material that is highly heat resistant and has excellent electrical insulating properties, so that the backing plate is not exposed.

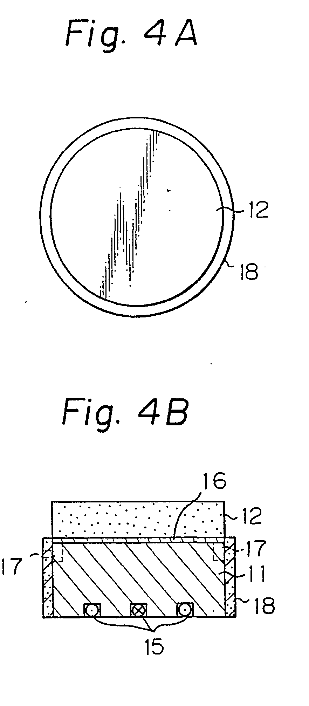

An example of sputtering apparatus used in the process embodying the invention will now be described with reference to Figs. 4A and 4B of the accompanying drawings, which are plan and sectional side views, respectively, showing an example of a combination of a target and a backing plate used in a sputtering technique embodying the invention.

Referring to Figs. 4A and 4B, a material 18 having an annular shape and an inner diameter substantially equal to the outer diameter of a backing plate 11, which has excellent electrical insulating properties and is highly heat-resistant, is fitted on the peripheral portion of the backing plate 11. The fitting may be bind fitting or free fitting, and a target 12 composed of, for example, chromium is bonded to the top face of the backing plate 11 of copper so that copper is not exposed. The bonding is effected with the aid of a metal 16 such as indium. If this arrangement is adopted, the portion 17, where copper is sputtered with ionized molecules of argon or the like in the conventional technique, is completely covered with the non-conductor and is not sputtered. Accordingly, only the material to be sputtered is sputtered on the substrate.

As the heat-resistant and electrically insulating material 18 it is preferred to use materials which have an insulation resistance of at least $10 \, k \cdot \Omega/cm$ and a softening point of at least 1,000°C. Such materials include, for example, ceramic, porcelain, alumina, and quartz glass. The thickness of the target 12 is not particularly critical. For example, the thickness of the target may be about 6 mm.

A pipe 15 for circulation of cooling water is laid out on the backing plate 11 on the side opposite to the side to be secured to the target 12.

In the foregoing example, the technique of forming a Cr film on a glass substrate has been illustrated, but the present invention is not limited to this embodiment; embodiments of the invention could be applied to the formation of a film of such a metal as Al or Au on a semiconductor wafer, for example.

According to the invention, the entire peripheral portion of the backing plate used in the sputtering step is covered with a heat-resistant, electrically insulating material. Accordingly the thin metal from formed by sputtering is not contaminated with copper or other metal emitted from the backing plate, and the thin metal film which is formed can readily be dry-etched.

## Claims

1. A process for preparing a patterned thin metal film comprising the steps of sputtering a sputtering target by applying a voltage to the sputtering target in a vacuum chamber to form a thin metal film on a substrate and then dry-etching the thin metal film to effect patterning thereof, wherein said sputtering target is composed of chromium, aluminium or gold, is bonded without an intervening insulating layer to a backing plate composed of a metal different from the sputtering target and containing copper, and covers the entire front surface of said backing plate, and the entire peripheral portion of the backing plate is covered with a material that is highly heat-resistant and has excellent electrical insulating properties so that the backing plate is not exposed.

2. A process according to claim 1, wherein the heat-resistant and electrically insulating material is selected from the group consisting of ceramic, porcelain, alumina and quartz glass.

3. A process according to claim 1 or claim 2, wherein a pipe for circulation of cooling water is arranged on the surface of the backing plate on the side opposite to the side bonded to the sputtering target.

## Patentansprüche

1. Verfahren zur Herstellung eines gemusterten dünnen Metallfilms, welches die Schritte der Zerstäubung eines Zerstäubungstarget durch Aufbringen einer Spannung auf das Zerstäubungstarget einer Vakuumkammer umfaßt, um einen dünnen Metallfilm auf einem Substrat zu bilden, um dann das Trockenätzen des dünnen Metallfilmes, um dessen Musterung zu bewirken, wobei das Zerstäubungstarget Chrom, Aluminium oder Gold besteht, ohne eine dazwischenliegende Isolierschicht mit einer Stützplatte verbunden ist, die aus einem Metall besteht, welches von dem Zerstäubungstarget unterschiedlich ist und Kupfer enthält, und die gesamte vordere Oberfläche der Stützplatte bedeckt, und der gesamte periphere Abschnitt der Stützplatte mit einem Material bedeckt ist, das hoch hitzebeständig ist und exzellente elektrische Isolationseigenschaften hat, so daß die Stützplatte nicht exponiert wird.

2. Verfahren nach Anspruch 1, bei dem das hitzebeständig und elektrisch isolierende Material ausgewählt ist aus der Gruppe bestehend aus Ceramic, Porzellan, Tonerde und Quartzglas.

3. Verfahren nach Anspruch 1 oder 2, bei dem ein Rohr zur Zirkulation von Kühlwasser auf der Oberfläche der Stützplatte auf der Seite gegenüber derjenigen Seite angeordnet ist, welche mit dem Zerstäubungstarget verbunden ist.

## Revendications

1. Procédé de préparation d'une mince pellicule métallique à motif, comprenant les étapes de pulvérisation cathodique d'une cible de pulvérisation cathodique par application d'une tension à la cible de pulvérisation cathodique dans une chambre à vide pour former une mince pellicule métallique sur un substrat, puis de gravure à sec de la mince pellicule métallique pour former un motif sur celle-ci, dans lequel ladite cible de pulvérisation cathodique est composée de chrome, d'aluminium ou d'or, est fixée sans couche isolante intermédiaire sur une plaque de support constituée par un métal différent de celui de la cible de pulvérisation cathodique et contenant du cuivre, et recouvre toute la surface frontale de ladite plaque de support, et toute la partie périphérique de la plaque de support est recouverte d'un matériau à haute résistance à la chaleur et qui présente d'excellentes propriétés d'isolation électrique, de sorte que la plaque de support n'est pas exposée.

2. Procédé selon la revendication 1, dans lequel le matériau résistant à la chaleur et électriquement isolant est choisi dans le groupe qui consiste en les céramiques, la porcelaine, l'alumine et le verre quartzeux.

3. Procédé selon la revendication 1 ou la revendication 2, dans lequel une conduite de circulation d'eau de refroidissement est disposée sur la surface de la plaque de support du côté opposé au côté fixé à la cible de pulvérisation cathodique.

## Fig. 1

## Fig. 2

## Fig. 3

# Fig. 4A

# Fig. 4B